Europäisches Patentamt

European Patent Office

Office européen des brevets

(11) Publication number: **0 465 726 A1**

# EUROPEAN PATENT APPLICATION

(21) Application number: **90201774.8**

(22) Date of filing: **03.07.90**

(51) Int. Cl.5: **C08J 7/04**, C09D 133/06, C23C 14/20

(43) Date of publication of application:
**15.01.92 Bulletin 92/03**

(84) Designated Contracting States:
**AT BE CH DE DK ES FR GB GR IT LI LU NL SE**

(71) Applicant: **AGFA-GEVAERT naamloze vennootschap**
**Septestraat 27**
**B-2510 Mortsel(BE)**

(72) Inventor: **Van Haute, Robert Cyriel**
**Velle 42**
**B-9140 Temse(BE)**
Inventor: **Leenders, Luc Herwig**
**Lichtaartseweg 182**
**B-2200 Herentals(BE)**
Inventor: **D'Hont, Dirk Marc**
**Ridder Van Ranstlei 37**
**B-2640 Mortsel(BE)**

(54) Improvement of the adhesion of a vacuum deposited metal to a polyester film.

(57) The present invention relates to a vacuum metallized polyester film support comprising on said polyester film support in the order given (i) a coating of copolymer of vinylidene chloride, an acrylic ester and itaconic acid, and (ii) a vacuum deposited metal layer. The present invention accomplished an improved adhesion of said metal layer to said polyester film support and less pinholes in the metal layer.

EP 0 465 726 A1

EP 0 465 726 A1

## BACKGROUND OF THE INVENTION

The present invention relates to a vacuum metallized polyester film support. In particular the present invention relates to an improvement of the adhesion of a metal layer to a polyester film support and an improvement of the number of pinholes formed in said metal layer.

Vacuum metallized polyester film supports can be used in a variety of applications such as in packaging materials, printing plates, as a support in photographic or electrophotographic materials, for direct-read-after-write applications, for mirrors etc. . Some of these applications impose high demands on the properties of the vacuum metallized polyester film support. For example the use of a metallized polyester film support for the production of printing plates imposes high demands on the adhesion of the metal layer to the polyester film support in order to obtain high printing endurance. Furthermore the use of a vacuum metallized polyester film support in direct-read-after-write applications, the appearance of pinholes in the metal layer is undesirable.

These high demands on the properties of the vacuum metallized polyester film support cannot be met by vacuum deposition of a metal on a simple polyester film supports.

It is an object of the present invention to improve the adhesion between a polyester film and a vacuum deposited metal layer thereon.

It is a second object of the invention to reduce the number of pinholes in the vacuum deposited metal layer.

Further objects of the invention will become clear in the following description.

## Summary of the invention

The present invention relates to a vacuum metallized polyester film support characterized therein that said polyester film support comprises a coating of a copolymer of vinylidene chloride, an acrylic ester and itaconic acid and thereon a vacuum deposited metal layer.

The present invention also relates to a method for the production of a vacuum metallized polyester film support characterized in that on said polyester film support a copolymer of vinylidene chloride, an acrylic ester and itaconic acid is coated whereupon a metal layer is applied by vacuum deposition.

## Detailed description of the invention.

It has surprisingly been found that if a polyester film support, preferably polyethyleneterephtalate, is coated with a copolymer of vinylidene chloride, an acrylic ester and itaconic acid, a subsequent vacuum deposited metal layer shows good adhesion to the polyester film support.

In a preferred embodiment of the invention the relative proportions of monomers in the 3-component copolymer of vinylidene chloride, an acrylic ester and itaconic acid, are within the following ranges:

| Monomer | Preferred Range (mol %) | Most Preferred Range (mol %) |
|---|---|---|
| Vinylidene chloride | 35.0 to 96 | 60 to 94 |
| Acrylic ester | 3.5 to 40 | 5 to 35 |
| Itaconic acid | 0.5 to 25 | 1 to 5 |

Useful acrylic esters in the copolymers are the alkyl esters of acrylic and methacrylic acids having from 1 to 18 carbon atoms in the alkyl group (e.g. methyl methacrylate, ethyl methacrylate, butyl methacrylate, octyl methacrylate, n-dodecyl methacrylate, n-octadecyl methacrylate, methyl acrylate, ethyl acrylate and propyl acrylate).

The copolymer may be prepared by various copolymerization methods. For example, the copolymerization may be conducted in aqueous dispersion containing a catalyst and activator, e.g., sodium persulphate and meta sodium bisulphite, and an emulsifying and/or dispersing agent. Alternatively, the copolymers of used with the present invention may be prepared by polymerization of the monomeric components in the bulk without added diluent, or the monomers may be reacted in appropriate organic solvent reaction media. The total catalyst-activator concentration should generally be kept within a range of about 0.01% to about 2.0% by weight of the monomer charge, and preferably within a range of concentration of 0.1% to 1.0%. Improved solubility and viscosity values are obtained by conducting the polymerization in the presence of mercaptans such as ethyl mercaptan, lauryl mercaptan, tertiary dodecyl mercaptan, etc., which are effective in reducing cross-linking in the copolymer. In general, the mercaptans should be used in concentrations of

2

0.1% to 5.0% by weight, based on the weight of polymerizable monomers present in the charge.

The copolymers used with the present invention can be coated on the hydrophobic film base or support by any suitable technique. They may be applied as an organic solvent solution or from aqueous dispersion. The coating solution may also contains $SiO_2$ in an amount of 0.5 % to 5 % by weight.

Examples of metals which can be vacuum deposited on said polyester film support coated with said copolymer of vinylidene chloride, acrylic ester and itaconic acid are e.g. tin, aluminum, tellurium, zinc, etc.. The metals can be vacuum deposited according to known methods.

The polyester film support is preferably biaxially stretched at an elevated temperature of e.g. 70-120 °C, reducing its thickness by about 1/2 to 1/9 or more and increasing its area 2 to 9 times. The stretching may be accomplished in two stages, transversally and longitudinally in either order or simultaneously.

Said copolymer of vinylidene chloride, an acrylic ester and itaconic acid can be applied before or after stretching of the polyester film support. It is preferably applied between the longitudinal and transversal stretch, in a thickness of 0.1 to 5 microns.

The invention will be further illustrated but is not intended to be limited by the following examples. All parts are by weight.

EXAMPLE 1 (comparitive example)

A polyethylene terephthalate polymer having an inherent viscosity of 0.57 dl/g was extruded at 290 °C, casted, cooled and subsequently longitudinally stretched at 110 °C. The stretching ratio was 3.3:1. The polyethylene terephthalate film was then cooled to 50 °C in a cooling station containing water kept at 16 °C. After drying said film was stretched transversely with a ratio of 3.3:1 at 100 °C and heat-set at a temperature of 205 °C for 1.5s. The beaded edges of the heat-set film were trimmed, the margins of the film were knurled and then the film was wound.

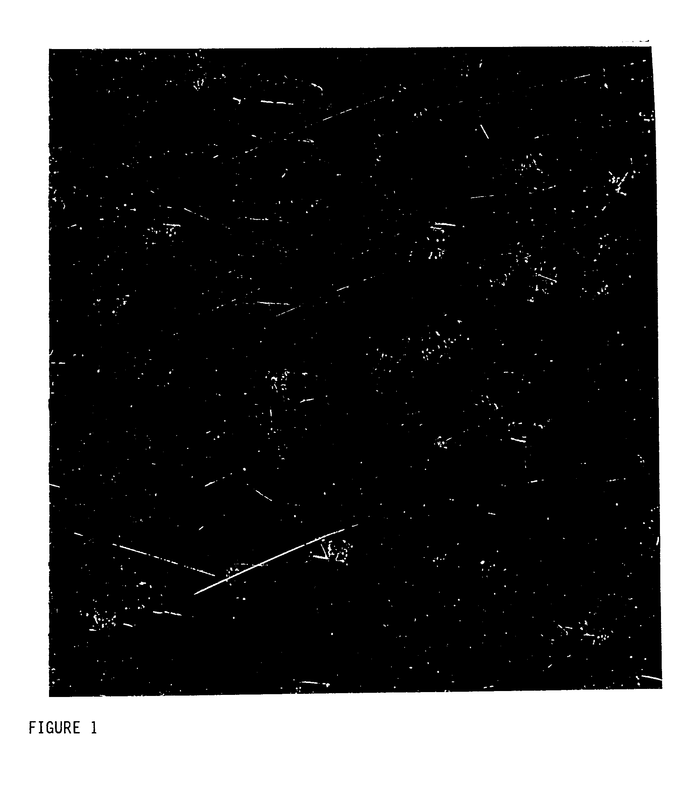

Aluminum was vacuum deposited on the thus obtained polyethylene terephthalate film using conventional methods. The optical density of the vacuum-deposited aluminum was between 3 and 4 as measured with a Mac-Beth TD904 densito meter equipped with an ortho filter and using a spot size of 3mm in diameter. An EM-graph of a representative sample of the surface of the vacuum-deposited aluminum layer is shown in figure 1.

EXAMPLE 2

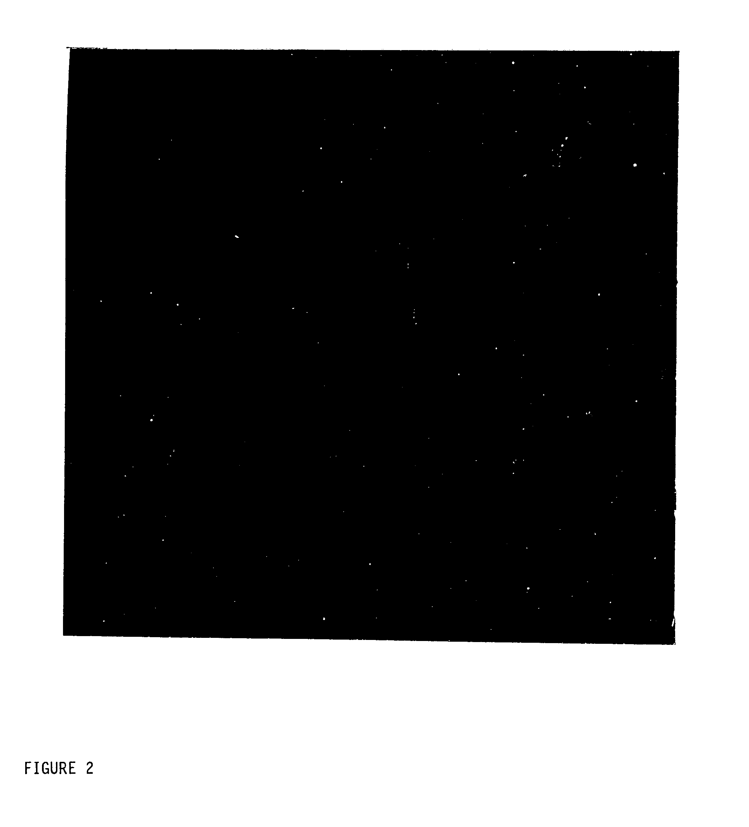

A polyethylene terephthalate film was prepared as described in example 1 except that an aqueous solution containing 12.5% of a copolymer consisting of 88 mol % of vinylidene chloride, 10 mol % of methylacrylate and 2 mol % of itaconic acid and 1.5% of $SiO_2$ was coated in amount of $0.42g/m^2$ of dry material between the longitudinally and transversely stretching of the film. The pH of the coating solution was adjusted to pH = 8.15 using $NH_4OH$. Aluminum was vacuum deposited on the thus obtained coated polyethylene terephthalate film support using conventional methods. The optical density of the vacuum-deposited aluminum was between 3 and 4 (measured as described in example 1). An EM-graph of a representative sample of the surface of the vacuum-deposited aluminum layer is shown in figure 2.

The comparison of figures 1 and 2 clearly shows the superior adhesion of aluminum to the polyethylene terephtalate film substrated with said vinylidene chloride-methylacrylate-itaconic acid copolymer as revealed by the small number of scratches and pinholes of the vacuum-deposited aluminum layer.

EXAMPLE 3

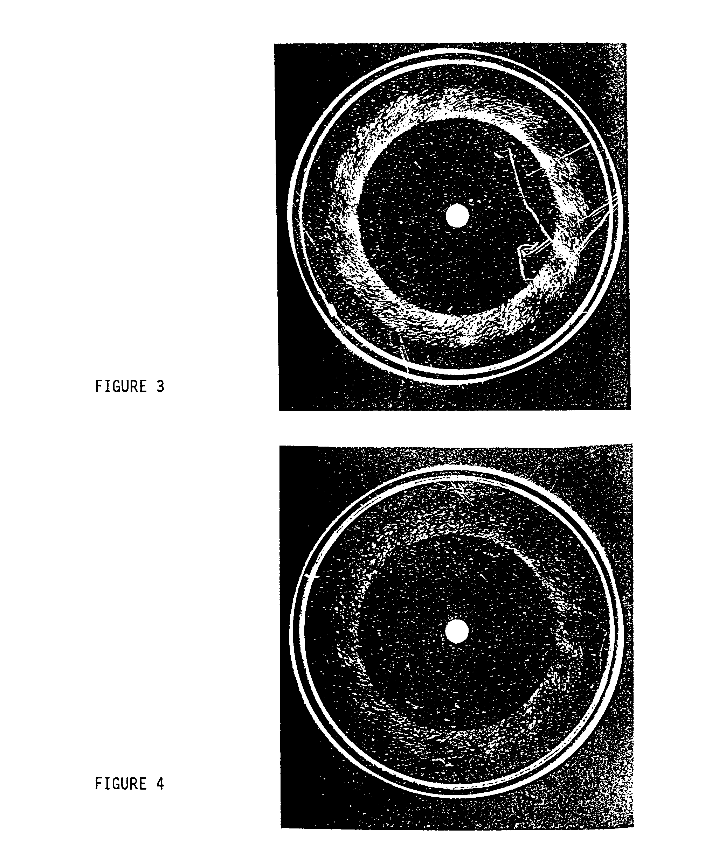

A vacuum metallized polyester film support prepared as discribed in example 1 was subjected to an abrasion test (ISO Dis 9352). An over-weight of 20g was applied to the friction roll. The friction roll was rotated at a rate of 40 r.p.m.. An EM-graph of the surface of the vacuum-deposited aluminum layer is shown in figure 3.

EXAMPLE 4

A vacuum metallized polyester film support prepared as described in example 2 was subjected to the same test as described in example 3. An EM-graph of the surface of the vacuum-deposited aluminum layer is shown in figure 4.

**Claims**

EP 0 465 726 A1

1. A vacuum metallized polyester film support comprising on said polyester film support in the order given (i) a coating of copolymer of vinylidene chloride, an acrylic ester and itaconic acid, and (ii) a vacuum deposited metal layer.

2. A vacuum metallized polyester film support according to claim 1 wherein the relative monomer proportions of the copolymer of vinylidene chloride, an acrylic ester and itaconic acid are 35 to 96 % of vinylidene chloride, 3.5 to 40 mol % of an acrylic ester and 0.5 to 25 mol % of itaconic acid.

3. A vacuum metallized polyester film support according to any of the preceding claims wherein the polyester film support is polyethylene terephthalate.

4. A vacuum metallized polyester film support according to any of the above claims wherein the vacuum deposited metal is aluminum.

5. A method for producing a vacuum metallized polyester film support characterized in that a copolymer of vinylidene chloride, an acrylic ester and itaconic acid, is coated directly on said polyester film support and a metal layer is subsequently applied by vacuum deposition.

6. A method for producing a vacuum metallized polyester film support according to claim 5 wherein the relative monomer proportions of the copolymer of vinylidene chloride, an acrylic ester and itaconic acid are 35 to 96 % of vinylidene chloride, 3.5 to 40 mol % of an acrylic ester and 0.5 to 25 mol % of itaconic acid.

7. A method for producing a vacuum metallized polyester film support according to claim 5 or 6 wherein the polyester film support is polyethylene terephthalate.

8. A method for producing a vacuum metallized polyester film support according to any of claims 5 to 7 wherein the vacuum deposited metal is aluminum.

9. A method for producing a vacuum metallized polyester film support according to any of claims 5 to 8 wherein the polyester film support has been biaxially stretched.

10. A method for producing a vacuum metallized polyester film support according to claim 9 wherein said copolymer is applied between the longitudinal and transversal stretch of the polyester film support.

4

FIGURE 1

FIGURE 2

FIGURE 3

FIGURE 4

European
Patent Office

EUROPEAN SEARCH
REPORT

Application Number

EP 90 20 1774

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X,Y | CHEMICAL ABSTRACTS, vol. 95, part 4, 27th July 1981, page 571, abstract no. 33489f, Columbus, Ohio, US; & JP-B-80 47 381 (TORAY INDUSTRIES) 29-11-1980 * Abstract * <br> – – – | 1-10 | C 08 J 7/04 <br> C 09 D 133/06 <br> C 23 C 14/20 |
| Y | DE-B-1 263 206   (E.I. DU PONT DE NEMOURS) * Claim 1; examples 1,7 * <br> – – – – – | 1-10 | |

| | |
|---|---|
| | TECHNICAL FIELDS SEARCHED (Int. Cl.5) |
| | C 08 J <br> C 23 C |

The present search report has been drawn up for all claims

| Place of search | Date of completion of search | Examiner |
|---|---|---|
| The Hague | 21 February 91 | HALLEMEESCH A.D. |